(19) Europäisches Patentamt
European Patent Office
Office européen des brevets

(11) **EP 3 951 002 B1**

(12) **EUROPEAN PATENT SPECIFICATION**

(45) Date of publication and mention
of the grant of the patent:
**03.04.2024 Bulletin 2024/14**

(21) Application number: **20777431.6**

(22) Date of filing: **02.03.2020**

(51) International Patent Classification (IPC):
*C23C 14/32* (2006.01)      *B22F 1/00* (2022.01)
*C22C 1/04* (2023.01)      *C22C 27/02* (2006.01)
*C22C 27/04* (2006.01)      *C23C 14/34* (2006.01)

(52) Cooperative Patent Classification (CPC):
(C-Sets available)
**C23C 14/3414; B22F 1/00; C22C 1/045;**
**C22C 27/025; C22C 27/04; C23C 14/325;**
B22F 1/052; B22F 2998/10                    (Cont.)

(86) International application number:
**PCT/JP2020/008600**

(87) International publication number:
**WO 2020/195565 (01.10.2020 Gazette 2020/40)**

(54) **V ALLOY TARGET**

V-LEGIERUNGS TARGET

CIBLE EN ALLIAGE V

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **26.03.2019 JP 2019057531**

(43) Date of publication of application:
**09.02.2022 Bulletin 2022/06**

(73) Proprietor: **Proterial, Ltd.**
**Tokyo 135-0061 (JP)**

(72) Inventors:
• **SOGAME, Hiroaki**
**Tokyo 108-8224 (JP)**
• **FUKUOKA, Jun**
**Tokyo 108-8224 (JP)**

(74) Representative: **Becker, Eberhard**
**Becker Kurig & Partner**
**Patentanwälte mbB**
**Bavariastraße 7**
**80336 München (DE)**

(56) References cited:
CN-A- 104 439 247      JP-A- 2009 068 047
JP-A- 2009 208 156      JP-A- 2015 142 944
JP-A- 2017 088 465

(52) Cooperative Patent Classification (CPC): (Cont.)

C-Sets
B22F 2998/10, B22F 1/09, B22F 3/1216, B22F 3/15;
B22F 2998/10, B22F 1/09, B22F 3/14;
B22F 2998/10, B22F 1/09, B22F 2003/1051

**Description**

[Technical Field]

The present invention relates to a V alloy target used to form a hard coating, for example.

[Background Art]

Hard coatings composed of V alloys, for example, are applied to surfaces of cutting tools, sliding components, molds, and the like for the purpose of improving abrasion resistance, seizure resistance, and the like. Also, Patent Literature 1, for example, proposes a hard coating containing V as a main constituent and one or more kinds of an M element, Si, and Al selected from a group 4a, a group 5a, and a group 6a. The hard coating composed of a V alloy is a useful technique in terms of excellent abrasion resistance, a low abrasion coefficient, and excellent slidability as compared with a hard coating composed of a Cr alloy in the related art.

Also, an ion plating method using a V alloy target (hereinafter, also simply referred to as a "target") as an evaporation source is typically applied to coating of a workpiece such as a cutting tool with a hard coating composed of the V alloy. Arc ion plating, which is a type of ion plating method, is a method for forming a hard coating by instantaneously dissolving and ionizing a target as a raw material of the hard coating through arc discharge in a depressurized reaction gas atmosphere and causing the ions to adhere to the negative voltage applied workpiece.

Applications of arc ion plating have been widespread until now since an ionization rate of evaporated metal is high as compared with an ion plating method using an electronic gun or the like and a hard coating with an excellent adhesive strength can be obtained. Also, a target used in arc ion plating is composed of a plate material with a desired composition that is similar to that of the hard coating to be obtained and is generally manufactured by a powder sintering method.

The hard coating formed using the target may peel off of the cutting tool or the sliding component during utilization, and an improvement in this regard is currently required because there are requirements for an increase in cutting speed of the cutting tool and an increase in reliability of the sliding tool.

[Citation List]

[Patent Literature]

[Patent Literature 1] Japanese Patent Laid-Open No. 2009-68047
Patent Literature 2

JP2017088465

[Summary of Invention]

[Technical Problem]

If a V-Ti target containing V as a main constituent and Ti selected as the M element as disclosed in Patent Literature 1 is produced through pressure-sintering with a hot isostatic press (hereinafter, referred to as a "HIP"), a local site with low hardness may be present in the target. Therefore, it may become difficult to adjust the surface roughness when the target is machine-worked into a predetermined shape and dimensions, and irregularities may occur in the surface.

Patent literature 2 discloses a sintered body containing vanadium, molybdenum and a metal carbide. The metal carbide is at least one compound selected from the group consisting of vanadium carbide and molybdenum carbide.

Also, in a case in which irregularities are present on a surface corresponding to an erosion surface, in particular, among target surfaces, there is a concern that abnormal discharge may be induced and droplets may fly off and adhere to a workpiece when a hard coating is formed on a workpiece through the arc ion plating.

Also, a V alloy is a so-called difficult-to-cut material with a high probability of occurrence of cracking, chipping, or dropping during machine working depending on the selection of additive elements. Moreover, if there is a local site with high hardness is present in the target, this may lead to abrasion or damage to a cutting tool tip, an increase in surface roughness of the obtained target, and damage to the target body in some cases.

An objective of the present invention is to provide a novel V alloy target that can suppress occurrence of irregularities on the surface of the target during machine working of the target and can suppress deposition of droplets on workpieces while suppressing occurrence of abnormal discharge during film formation.

[Solution to Problem]

A V alloy target according to the present invention is disclosed in claims 1 and 2.

[Advantageous Effects of Invention]

The present invention can provide a novel V alloy target with adjusted Vickers hardness on an erosion surface. Thus, it is possible to suppress occurrence of irregularities on a surface of a target and to also suppress adhesion of droplets on a workpiece while suppressing occurrence of abnormal discharge during film formation, in machine working of the target. Therefore, the present invention provides a useful technique for manufacturing a hard coating with excellent abrasion resistance, a small friction coefficient, and excellent slidability, for example, as described above.

[Description of Embodiments]

A target according to the present invention is a V alloy composed of V and Mo, has an average value of Vickers hardness of an erosion surface defined by JIS Z 2244 in a range of 250 to 350 HV, and has a variation in Vickers hardness measured at 5 measurement point of 20% or less. Hereinafter, the "average value of Vickers hardness in the erosion surface" will also simply be referred to as "Vickers hardness".
According to the target of the present invention, it is possible to suppress a roughened surface, to reduce occurrence of irregularities on the surface, and to obtain a target with a smooth surface when machine working such as cutting or polishing is performed to obtain a target shape and dimensions by setting the Vickers hardness within a specific range and reducing the variation thereof [(a maximum value - a minimum value)/(the maximum value + the minimum value)] $\times$ 100 (%). According to the target of the present invention, it is thus possible to suppress induction of abnormal discharge and adhesion of flying droplets to a workpiece. Also, the target according to an embodiment of the present invention preferably has a variation in Vickers hardness measured at arbitrary 5 measurement points of 15% or less.
Also, according to the target of the present invention, it is possible to suppress generation of a built-up edge at a tip of a mill or a lathe, for example, by adjusting the Vickers hardness such that it is within the specific range. In other words, according to the target of the present invention, it is possible to suppress a gradual increase in the amount of cutting of the tip that accompanies growth in a built-up edge with the progress of cutting, to reduce dimensional differences in the target between at the time of starting of the cutting and at the time of completion of cutting, and also to suppress damage to the tip when a built-up edge peels off.
On the other hand, if a site with low hardness is present in an erosion surface of the target, for example, in a V matrix phase, only the site with low hardness may remain or drop off, and the surface of the erosion surface of the target becomes rough and is likely to serve as a start point of abnormal discharge during film formation. Therefore, the Vickers hardness of the target according to the present invention is set to be 250 HV or more. Also, the Vickers hardness of the target according to the embodiment of the present invention is preferably set to 270 HV or more for the same reason.
According to the target of the present invention, it is possible to suppress the amount of abrasion of the tip of the mill or the lathe, for example, by setting the Vickers hardness to be 350 HV or less. In other words, according to the target of the present invention, it is possible to suppress a gradual decrease in amount of cutting of the tip that accompanies abrasion of the tip with a progress of the cutting and an increase in a dimensional difference of the target at the time of the starting of the cutting and at the time of the completion of the cutting, and also to suppress damage of the tip.
Also, according to the target of the present invention, it is possible to suppress damage on the target body due to chucking of the cutting machine, handling at the time of attachment to an arc ion plating apparatus, and the like by setting the Vickers hardness to 350 HV or less. Also, the Vickers hardness of the target according to the embodiment of the present invention is preferably set to 340 HV or less for the same reason.
The Vickers hardness stated in the present invention is measured at arbitrary 5 points aligned laterally in a line at measurement intervals with a distance such that that there is no influence on measurement between indentations in terms of suppression of deformation of the aforementioned target and abrasion and damage to the tip of the cutting tool and suppress of abnormal discharge at the time of arc ion plating. At this time, a load is set to 9.8 N, and a pressurization time is set to 10 seconds.
Also, the target according to the present invention has an average value of Vickers hardness measured under the aforementioned conditions in a range of 250 to 350 HV and has a variation [(the maximum value - the minimum value)/(the maximum value + the minimum value)] $\times$ 100 (%) of 20% or less.
Also, the target according to the embodiment of the present invention is preferably composed of a structure in which minute pieces of Mo phase are distributed in a V matrix phase in terms of the setting of the Vickers hardness to 250 to 350 HV

The target according to the present invention is composed of V and Mo. The content of Mo can be appropriately adjusted within a range in which abrasion resistance, slidability, and corrosion resistance are not significantly degraded, and the target contains 10 to 50 at% of Mo with the remainder including V and inevitable impurities. Also, the content of Mo is preferably set to 15 at% or more for the same reason as that described above. Also, the content of Mo is preferably set to 25 at% or less for the same reason as that described above.

The target according to the present invention is obtained by a powder sintering method. Specifically, the target is obtained by pressure-sintering a powder mixture of pure metal powders or alloy powders mixed together or a single type of powder in which a final composition is adjusted such that the aforementioned constituent composition is obtained. Also, it is possible to apply an HIP method, a hot press method, or an electric current sintering method, for example, for the pressure sintering.

Here, according to the present invention it is preferable to use a powder with a 50% particle diameter in a volume-standard cumulative particle size distribution (hereinafter, referred to as "D50") in a range of 1 to 200 $\mu$m as the raw material powder applied to the pressure sintering in terms of homogeneity of the target structure.

The pressure sintering is preferably performed under conditions of a sintering temperature of 900 to 1300°C, a pressurization pressure of 50 to 200 MPa, and for 1 to 15 hours.

It is possible to cause the sintering of the powder to progress and to suppress occurrence of pores by setting the sintering temperature to 900°C or more. Also, it is possible to suppress dissolving of the powder by setting the sintering temperature to 1300°C or less.

Also, it is possible to promote progress of the sintering and to suppress occurrence of pores by setting the pressurization pressure to 50 MPa or more. In addition, it is possible to suppress introduction of a remaining stress into the target at the time of the sintering and to suppress occurrence of cracking after the sintering by setting the pressurization pressure to 200 MPa or less.

Moreover, it is possible to promote a progress of the sintering and to suppress occurrence of pores by setting the sintering time to 1 or more hours. Also, it is possible to suppress degradation of manufacturing efficiency by setting the sintering time to 15 hours or less.

Examples

First, V powder with a D50 of 140 $\mu$m and Mo powder with D50 of 5 $\mu$m were prepared. Then, in order to obtain a target in Example 1 of the present invention, amounts of the powders prepared as described above were taken to produce a compositional formula of $V_{90}$-$Mo_{10}$ in terms of an atom ratio, were mixed with a V-type mixer, were put into a capsule made of soft iron, and were then degasified and sealed under conditions of 450°C for 4 hours. Then, the capsule was pressure-sintered by using the HIP under conditions of 1250°C, 120 MPa, and 10 hours, thereby producing a sintered article.

In order to obtain a target in Example 2 of the present invention, the powder prepared as described above was scaled to satisfy a composition formula $V_{80}$-$Mo_{20}$ at an atomic ratio, was then mixed with a V-type mixer, was put into a capsule made of soft iron, and was degasified and sealed under conditions of 450°C and 4 hours. Then, the capsule was pressure-sintered by the HIP under conditions of 1250°C, 120 MPa, and 10 hours, thereby producing a sintered article.

In order to obtain a target in Example 3 of the present invention, the powder prepared as described above was scaled to satisfy a composition formula $V_{65}$-$Mo_{35}$ at an atomic ratio, was then mixed with a V-type mixer, was put into a capsule made of soft iron, and was degasified and sealed under conditions of 450°C and 4 hours. Then, the capsule was pressure-sintered by the HIP under conditions of 1250°C, 120 MPa, and 10 hours, thereby producing a sintered article.

In order to obtain a target in Example 4 of the present invention, the powder prepared as described above was scaled to satisfy a composition formula $V_{50}$-$Mo_{50}$ at an atomic ratio, was then mixed with a V-type mixer, was put into a capsule made of soft iron, and was degasified and sealed under conditions of 450°C and 4 hours. Then, the capsule was pressure-sintered by the HIP under conditions of 1250°C, 120 MPa, and 10 hours, thereby producing a sintered body.

In order to obtain a target in a comparative example, V powder with D50 of 140$\mu$m and Ti powder with D50 of 106 $\mu$m were prepared. Then, the powder prepared as described above was scaled to satisfy a composition formula $V_{50}$-$Ti_{50}$ at an atomic ratio, was mixed with a V-type mixer, was put into a capsule made of soft iron, and was degasified and sealed under conditions of 450°C and 4 hours. Then, the capsule was pressure-sintered by the HIP under conditions of 850°C, 120 MPa, and 1 hour, thereby producing a sintered article.

Each of the thus obtained sintered articles was machine-worked, thereby producing a target. At this time, it was possible to confirm that no irregularities occurred at the time of the machine working and the surfaces were in a smooth state in all the targets in Examples 1 to 4 of the present invention.

On the other hand, irregularities occurred in the target in the comparative example during the machine working, and irregularities were observed on the surface of the target.

Test pieces were acquired by machine working from arbitrary positions of surfaces of the thus obtained targets, which served as erosion surfaces. Then, Vickers hardness was measured at arbitrary 5 points aligned laterally in a line at measurement intervals with a distance therebetween such that there is no influence on measurement between indentations, using MVK-E manufactured by Akashi Seisakusho Ltd., in accordance with JIS Z 2244. The results are shown in Table 1.

It was confirmed that there was a site with Vickers hardness below 250 HV, and it was also confirmed that the variation [(the maximum value - the minimum value)/(the maximum value + the minimum value)] $\times$ 100(%) exceeded 20%, in the target in the comparative example.

On the other hand, it was confirmed that all the targets in Examples 1 to 4 of the present invention had Vickers hardness in a range of 250 to 350 HV. When average values of the Vickers hardness were obtained, the targets in Examples 1 to 4 of the present invention were within the preferable range of the Vickers hardness of a range of 250 to 350 HV at all the measurement points. Also, it was confirmed that the variation [(the maximum value - the minimum value)/(the maximum value + the minimum value)] $\times$ 100(%) was adjusted to 20% or less in all the targets in Examples 1 to 4 of the present invention. In this manner, the targets according to the present invention were able to have smooth target surfaces at the time of the machine working and became useful as targets for forming hard coatings.

[Table 1]

| | Composition formula [at%] | Vickers hardness [HV1/10] | | | | | | |
|---|---|---|---|---|---|---|---|---|
| | | Measurement point | | | | | Average value | Variation % |
| | | 1 | 2 | 3 | 4 | 5 | | |
| Example 1 of the invention | $V_{90}$-$Mo_{10}$ | 290 | 285 | 279 | 284 | 294 | 286 | 3 |
| Example 2 of the invention | $V_{80}$-$Mo_{20}$ | 293 | 290 | 280 | 273 | 288 | 285 | 4 |
| Example 3 of the invention | $V_{65}$-$Mo_{35}$ | 327 | 323 | 325 | 321 | 319 | 323 | 1 |
| Example 4 of the invention | $V_{50}$-$Mo_{50}$ | 319 | 257 | 268 | 274 | 278 | 279 | 11 |
| Comparative Example | $V_{50}$-$Ti_{50}$- | 257 | 205 | 115 | 189 | 271 | 207 | 40 |

**Claims**

1. A V alloy target comprising: V and Mo, wherein an average value of Vickers hardness on an erosion surface is in a range of 250 to 350 HV, and a variation in Vickers hardness measured at 5 measurement points is 20% or less, wherein

   the V alloy target contains 10 to 50 at% of Mo with a remainder including V and inevitable impurities,
   the V alloy target is obtained by pressure-sintering a powder mixture of pure metal powders or alloy powders mixed together or a single type of powder in which a final composition is adjusted such that the aforementioned constituent composition is obtained, and
   the variation is determined by the following formula:

$$[(\text{a maximum value of the measurement points} - \text{a minimum value of the measurement points})/(\text{the maximum value of the measurement points} + \text{the minimum value of the measurement points})] \times 100\ (\%).$$

2. The V alloy target according to claim 1, wherein the average value of the Vickers hardness is in a range of 270 to 340 HV

6

**Patentansprüche**

1. V-Legierungstarget, umfassend: V und Mo, wobei ein Durchschnittswert der Vickershärte auf einer Erosionsoberfläche in einem Bereich von 250 bis 350 HV liegt und eine Variation der Vickershärte, gemessen an 5 Messpunkten, 20 % oder weniger beträgt, wobei

 das V-Legierungstarget 10 bis 50 AT% Mo enthält, wobei der Rest V und unvermeidbare Verunreinigungen enthält,
 das V-Legierungstarget durch Drucksintern eines Pulvergemischs aus reinen Metallpulvern oder aus miteinander vermischten Legierungspulvern oder aus einem einzigen Pulvertyp erhalten wird, bei dem eine endgültige Zusammensetzung so eingestellt wird, dass die vorstehend genannte Zusammensetzung der Bestandteile erhalten wird, und
 die Variation durch die folgende Formel bestimmt wird:

$$[(\text{ein Maximalwert der Messpunkte - ein Minimalwert der Messpunkte})/(\text{der}$$

$$\text{Maximalwert der Messpunkte + der Minimalwert der Messpunkte})] \times 100 \ (\%).$$

2. V-Legierungstarget gemäß Anspruch 1, wobei der Durchschnittswert der Vickershärte in einem Bereich von 270 bis 340 HV liegt.

**Revendications**

1. Cible en alliage de V comprenant : V et Mo, dans laquelle une valeur moyenne de dureté Vickers sur une surface d'érosion est comprise dans une plage de 250 à 350 HV, et une variation de dureté Vickers mesurée en 5 points de mesure est de 20 % ou moins, dans laquelle

 la cible en alliage de V contient de 10 à 50 % atomique de Mo, le reste comprenant du V et des impuretés inévitables,
 la cible en alliage de V est obtenue par frittage sous pression d'un mélange pulvérulent de poudres de métaux purs ou de poudres d'alliages mélangées ensembles ou d'un type unique de poudre dans laquelle une composition finale est ajustée de sorte à obtenir la composition de constituants susmentionnée, et
 la variation est déterminée par la formule suivante :

$$[(\text{une valeur maximale des points de mesure} - \text{une valeur}$$

$$\text{minimale des points de mesure})/(\text{la valeur maximale des}$$

$$\text{points de mesure} + \text{la valeur minimale des points de}$$

$$\text{mesure})] \times 100 \ (\%).$$

2. Cible en alliage de V selon la revendication 1, dans laquelle la valeur moyenne de la dureté Vickers est comprise dans une plage de 270 à 340 HV.

**EP 3 951 002 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009068047 A
- JP 2017088465 B